# EUROPEAN PATENT APPLICATION

(11) **EP 3 945 624 A1**
(43) Date of publication of application: **02.02.2022**
(21) Application number: 20188630.6
(22) Date of filing: 30.07.2020
(51) Int. Cl.: H01M 10/6554, H01M 10/653, H01M 8/04007, C08L 27/18, F28F 13/00, H01L 23/373, H01L 33/64, H05K 7/20, H01M 8/0243, C25B 9/00, D01D 5/00, D01F 6/12, C08J 9/00, C08K 3/38

(54) **COMPOSITE MATERIAL COMPRISING POLYTETRAFLUOROETHYLENE AND HEXAGONAL BORON NITRIDE PARTICLES**

(71) Applicant: 3M Innovative Properties Company, Saint Paul, MN 55133-3427 (US)
(72) Inventor: Muggli, Mark, 84547 Emmerting (DE); Zehentmaier, Sebastian, 83119 Obing (DE); Zimmermann-Ptacek, Johanna, 87561 Oberstdorf (DE); Zentis, Fee, 83329 Waging am See (DE); Steinbach Eva-Maria, 84508 Burgkirchen (DE)
(74) Representative: Mössner, Brigitte

(57) **Abstract**

The present disclosure relates to a composite material comprising polytetrafluoroethylene and hexagonal boron nitride particles, wherein the composite material is porous, and wherein the composite material is compressible.

The present disclosure further relates to a shaped article and a film comprising said composite material, and to a process for producing said composite material, and to the use of said composite material.

## Description

### Technical Field

The present disclosure relates to a composite material comprising polytetrafluoroethylene and hexagonal boron nitride particles.

### Background

Lithium ion batteries and fuel cells, in particular high temperature polymer electrolyte membrane fuel cells (HT-PEMFCs), generate much heat that needs to be dissipated or can be captured and used as thermal power. Since these devices often comprise stacks of a number of individual cells, these individual cells have to be carefully aligned. Nonetheless, there are height differences between individual cells that need to be compensated so that good contact to the cooling plate can be guaranteed. Oftentimes thermally conductive paste-like materials are used for thermal dissipation in lithium ion batteries and fuel cells. These paste-like materials ensure good contact to the cooling plate and compensate height differences between individual cells. However, these materials are hard to apply or are messy, and furthermore, they can be hard to remove, if repairs are necessary.

Another possibility for heat dissipation in lithium ion batteries and fuel cells would be to use thermally conductive films or sheets based on polymers. Thermally conductive fillers such as hexagonal boron nitride particles can be used to improve the thermal conductivity of polymers. Films or sheets can be produced based on polytetrafluoroethylene (PTFE). PTFE can withstand high temperatures and harsh chemical environments, and it is electrically insulating. Due to its non-sticking properties, PTFE is easy to remove after use or when repairs are needed.

US 8,985,818 B2 discloses a thermally conductive sheet comprising a fluororesin and boron nitride powder. The fluororesin contains 5 to 50% by mass of a fusible fluororesin and polytetrafluoroethylene. One major drawback of this sheet is that the material from which it is made is a dense material and not compressible, and the sheet cannot be used to fill gaps in stacked devices such as lithium ion batteries and fuel cells, as it cannot compensate height differences between individual cells.

US 2014/0251588 A1 discloses a sheet-shaped material comprising a porous base material comprising a fluorine resin and a thermally conductive filler such as boron nitride, and an adhesive material contained in pores of the porous base material, wherein the fluorine resin contains polytetrafluoroethylene. By filling the pores, a dense material is obtained and this sheet-shaped material is also not compressible.

WO 2004/099306 A1 discloses a thermally conductive heat exchange structure comprising a polymer composite comprising a major proportion of fluorocarbon polymer and a minor proportion of boron nitride. The polymer composite may be in the form of a shaped extruded article which is dense and not compressible.

There is still a need for thermally conductive materials and films that can compensate height differences between individual cells, and that can easily be applied and removed after use.

As used herein, "a", "an", "the", "at least one" and "one or more" are used interchangeably. The term "comprise" shall include also the terms "consist essentially of" and "consists of".

### Summary

In a first aspect, the present disclosure relates to a composite material comprising polytetrafluoroethylene and hexagonal boron nitride particles, wherein the composite material is porous, and wherein the composite material is compressible.

In another aspect, the present disclosure also relates to a shaped article comprising the composite material as disclosed herein. The shaped article may be a film.

In yet a further aspect, the present disclosure relates to a process for producing a composite material as disclosed herein, the process comprising
providing hexagonal boron nitride particles and polytetrafluoroethylene,
mixing the hexagonal boron nitride particles and polytetrafluoroethylene, thereby obtaining a powder mixture,
extruding the powder mixture into an extruded strand,
shaping the extruded strand into a shaped article, wherein the shaped article has a length, and
stretching the shaped article to a length of at least 200% of its unstretched length, thereby obtaining a shaped article of the composite material.

In yet a further aspect, the present disclosure relates to the use of the composite material, the shaped article and the film as disclosed herein for heat dissipation in heat generating systems such as lithium ion batteries, fuel cells, electrolyzers, inverters, power electronics or electrochemical devices.

The composite material disclosed herein can withstand high temperatures and harsh chemical environments. The composite material disclosed herein is thermally conductive and electrically insulating.

The composite material as disclosed herein can be compressed. By compressing the composite material, the thermal conductivity increases. The composite material, the shaped article and the film as disclosed herein can be used to improve heat dissipation out of heat generating devices. Due to the compressible properties of the film, it can be used to easily fill gaps in devices with stacked cells, such as fuel cells or lithium ion batteries, as it can compensate height differences between individual cells in such devices with a thermally conductive material. The film as disclosed herein can easily be applied. Since the composite material is based on polytetrafluoroethylene and has non-sticking properties, it can be easily removed after use or when repairs are needed.

In addition, the composite material disclosed herein has low dielectric properties, specifically low permittivity and low loss factor, due to the use of boron nitride as thermally conductive filler and PTFE as the matrix. Also, the water absorption of the composite material is also low because both boron nitride and PTFE are hydrophobic.

### Brief Description of the Drawings

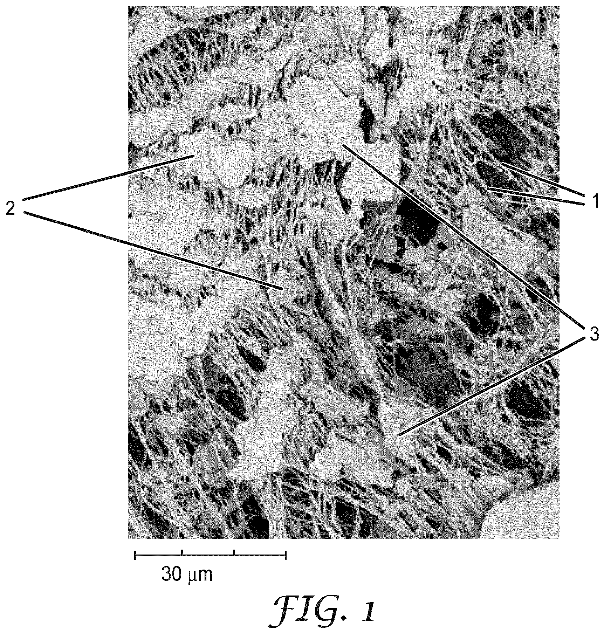

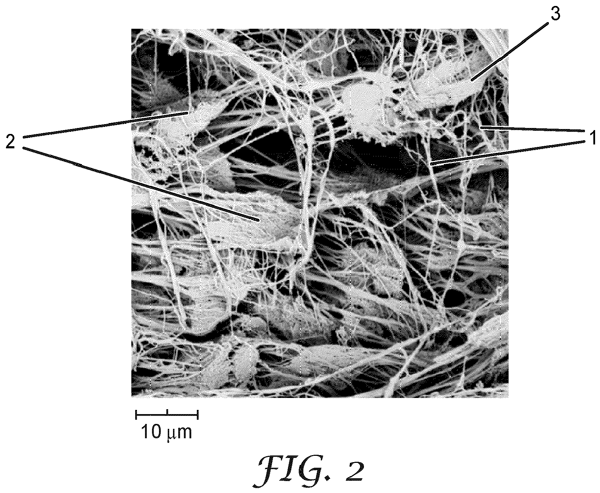

The present disclosure is explained in more detail on the basis of the drawings, in which
Figures 1 and 2 show scanning electron micrographs of the microstructure of the composite material as disclosed herein.

### Detailed Description

The composite material disclosed herein comprises polytetrafluoroethylene and hexagonal boron nitride particles.

As used herein, polytetrafluoroethylene is a homo- or copolymer of tetrafluoroethene (TFE). Tetrafluoroethene (TFE) homopolymers and TFE copolymers with up to 1% by weight of other perfluorinated monomers are called polytetrafluoroethylene (also referred to as polytetrafluoroethene or PTFE).

PTFE typically has a very high molecular weight, typically about 10⁶ g/mole or greater. This high molecular weight leads to a very high melt viscosity (about 10¹⁰ - 10¹³ Pa·s at 380°C), which makes PTFE not accessible to melt processing like extrusion. PTFE is therefore "non melt-processable". The property of being "melt-processable" or not is generally determined by the melt flow index (MFI). The MFI measures the amount of polymer that can be pushed through a die at a specified temperature (here 372°C) using a specified weight (here 5 kg). Thus, the MFI is a measure for the suitability for melt-processing a polymer. Non melt processable fluoropolymers have an MFI (372/5) of less than 0.1 g/10 min. Since they cannot be processed from the melt by ordinary melt-processing techniques like melt extrusion or injection molding, special processing techniques have to be used to make shaped PTFE articles. Such techniques include paste extrusion and compression molding.

Due to its resistance to chemical and high thermal service temperatures, the non-melt processable PTFE is frequently used as gaskets and sealing materials in demanding applications, for example in the aircraft, motorcraft and water industry and in chemical engineering.

It has now been found that compressible composite materials comprising PTFE and hexagonal boron nitride particles as described herein show an improved thermal conductivity when compressed and can be used to fill gaps in stacked devices such as lithium ion batteries and fuel cells, as it can compensate height differences between individual cells.

The PTFE typically has a melting point within the range of 327 +/-10 °C. The PTFE is solid at ambient conditions (23 °C, 1 bar).

The PTFE is perfluorinated. This means it only contains units derived from TFE or from TFE and one or more perfluorinated comonomers. Perfluorinated monomers include perfluorinated alpha-olefins (general formula CₙF₂ₙ with n being an integer of 2 to 10). A specific example is hexafluoropropylene (HFP). Other perfluorinated monomers include perfluorinated alkyl or allyl ethers (general formula CF₂=CF-(CF₂)ₙ-O-R_{f}, wherein n represents either 0 or 1 and R_{f} represents a linear or branched, cyclic or acyclic perfluorinated alkyl residue containing no, one or more than one catenary oxygen atom. R_{f} may contain up to 8, preferably, or up to 6 carbon atoms, such as 1, 2, 3, 4, 5 and 6 carbon atoms. Specific examples include but are not limited to perfluoroalkyl ethers (PAVE), like perfluoromethylether (PMVE) or perfluoropropylvinylether (PPVE).

PTFE is typically obtained by radical polymerisation initiated by a free radical initiator. The polymerisation is typically carried out in an aqueous phase. The polymerisation may be carried out as emulsion polymerisation or as suspension polymerisation.

Suspension polymerisations generally are carried out in an aqueous phase and in the absence of emulsifiers. In a suspension polymerisation the reaction mixture coagulates and settles as soon as stirring of the reaction mixture is discontinued. The resulting polymer particles are generally of bigger size than those obtained by emulsion polymerisation. Typically, the polymer particles obtained by emulsion polymerisations are in the range of 50 to 500 nm while the polymer particles with particle sizes of up to 800 µm may be obtained by suspension polymerisation. The particle size of the particles obtained after the polymerisation may be increased by agglomeration (for example adding hydrocarbons or other agglomerants to the particles) or decreased by milling. Since no fluorinated emulsifiers are used, suspension PTFE is free of fluorinated emulsifiers, for example free of the fluorinated emulsifiers described below.

In aqueous emulsion polymerisation the polymerisation is carried out in a way that stable dispersions are obtained. The dispersions remain stable (no phase separation) after stirring of the reaction mixture has stopped for at least 2 hours, or at least 12 hours, or at least 24 hours, or at least 48 hours. Typically, fluorinated emulsifiers are employed in the aqueous emulsion polymerisation. The fluorinated emulsifier is typically used in an amount of 0.01% by weight to 1% by weight based on solids (polymer content) to be achieved. Suitable emulsifiers include any fluorinated emulsifier commonly employed in aqueous emulsion polymerization.

Typical emulsifiers correspond to the general formula:

Y-R_{f}-Z-M

wherein Y represents hydrogen, CI or F; R_{f} represents a linear or branched perfluorinated alkylene having 4 to 10 carbon atoms; Z represents COO⁻ or SO₃⁻ and M represents a cation like an alkali metal ion, an ammonium ion or H⁺. Exemplary emulsifiers include: ammonium salts of perfluorinated alkanoic acids, such as perfluorooctanoic acid and perfluorooctane sulphonic acid.

Also emulsifiers of the general formula [R_{f}-O-L-COO⁻]ᵢXᵢ⁺ can be used wherein L represents a linear or branched partially or fully fluorinated alkylene group or an aliphatic hydrocarbon group, R_{f} represents a linear or branched, partially or fully fluorinated aliphatic group or a linear or branched partially or fully fluorinated group interrupted with one or more oxygen atoms, Xᵢ⁺ represents a cation having the valence i and i is 1, 2 and 3. In case the emulsifier contains a partially fluorinated aliphatic group, it is referred to as a partially fluorinated emulsifier. Preferably, the molecular weight of the emulsifier is less than 1,000 g/mole. Specific examples are described in, for example, US Pat. Publ. 2007/0015937 (Hintzer et al.).

The PTFE used for the composite material provided herein may be in powder form. The powder PTFE has particles having a size (i.e. diameter or length) of from about 5 to about 800 µm. The powder PTFE may also be referred to as "fine powder PTFE".

Preferably the particles of the fine powder PTFE have an average particle size of about 10 to about 650 µm. The average particle size of the fine powder PTFE can be determined by sieving and expressed as D50 value where 50 vol% of the particles are retained by a sieve having the respective mesh size.

Preferably the PTFE used, for example the fine powder PTFE, is "emulsion PTFE", i.e. PTFE obtained by emulsion polymerisation.

In the fine powder PTFE, the primary particles obtained by emulsion polymerization having a particle size of about 50 to 500 nm are agglomerated to secondary particles having a particle size of 5 to 800 µm. The particle size of the primary particles is measured by laser diffraction (ISO13320:2020).

The PTFE used for the composite material provided herein may also be in the form of an aqueous dispersion of the fine powder PTFE as described above, or in the form of an aqueous dispersion derived from the production of the PTFE, preferably by emulsion polymerization, and obtained before drying, and is referred to as "dispersion PTFE". The aqueous dispersion typically has a solids content of 15 to 30%. Dispersing agents known in the art may be used to stabilize the aqueous dispersion.

The fine powder PTFE described herein is commercially available for example from DuPont de Nemours & Company (DuPont), Solvay Solexis S.p.a. and 3M Company. Commercially available examples of suitable fine powder grade PTFE include trade designated DYNEON TF 2021Z, TF 2025Z, TF 2029Z, TF 2035Z, TF 2071Z, TF 2072Z, TF 2073Z and TFM 2001Z, TFM 2033Z, TFM 2070Z, all of which are available from 3M Company, St. Paul, MN, U.S.A.

The composite material as disclosed herein may further comprise up to 30% by weight of fluoropolymers other than polytetrafluoroethylene, based on the total weight of fluoropolymers. Preferably, the melting point of the fluoropolymers other than PTFE is higher than the stretching temperature of the composite material.

In some embodiments of the composite material disclosed herein, the composite material does not comprise a fluoropolymer other than polytetrafluoroethylene.

The composite material is porous.

Typically, the composite material has a porosity of at least 10%. The composite material may have a porosity of at least 20%, or of at least 30%, or of at least 40%, or of at least 50%, or of at least 60%, or of at least 70%. Typically, the composite material has a porosity of at most 90%. Preferably, the composite material has a porosity of at least 50%. More preferably, the composite material has a porosity of from 50% to 90%. In some embodiments, the composite material has a porosity of from 70% to 90%.

The composite material as disclosed herein comprises a plurality of nodes which are interconnected by a plurality of fibrils. Typically, the nodes have a diameter of from 1 to 50 µm. The diameter is measured as the maximum diameter on scanning electron micrographs of the composite material. The fibrils which connect the individual nodes with one another may have a diameter of from 80 to 2000 nm and a length of from 1 to 50 µm.

The nodes and the fibrils comprise polytetrafluoroethylene. The nodes and the fibrils may consist of polytetrafluoroethylene. The hexagonal boron nitride particles may be located near the nodes or within the nodes. The hexagonal boron nitride particles may also be located near the fibrils or may be connected to the fibrils. The fibrils may be mechanically anchored to the hexagonal boron nitride particles, or, in other words, the hexagonal boron nitride particles may act as nodes to which the fibrils are mechanically anchored. The porosity of the composite material results from pores that are located between the fibrils.

Figures 1 and 2 show scanning electron micrographs (SEM) of the microstructure of the composite material as disclosed herein. They represent a top view of the stretched film of Example 3 of the examples section below. Figure 1 has a magnification of 2000x, Figure 2 has a magnification of 4000x. The arrows in the figures point to the fibrils (1), the nodes (2) and the hexagonal boron nitride platelets (3). The figures also show the pores that are located between the fibrils.

The composite material as disclosed herein is compressible. Typically, the composite material is compressible by at least 10% in direction of compression. This means that the composite material is uniaxially compressible and that the sample thickness of a sample of the composite material in direction of compression is at least 10% lower than before compression, and the compressed thickness of the sample is at most 90% of the thickness of the composite material in the uncompressed state.

The composite material may be compressible by at least 30% or by at least 40%, or by at least 50%, or by at least 60%, or by at least 70% in direction of compression. Typically, the composite material is compressible by at most 80% in direction of compression. In some embodiments, the composite material is compressible by at least 60% and by at most 80% in direction of compression. The density of the compressed composite material may be only slightly below the theoretical density of the composite material, which means that the porosity of the compressed composite material can be very low and only a small amount of pores of below 10% may remain. The theoretical density of the composite material is calculated from the powder density of hexagonal boron nitride which is 2.27 g/cm³, the density of polytetrafluoroethylene which is 2.2 g/cm³, and from the fractions of hexagonal boron nitride and polytetrafluoroethylene in the composition of the composite material.

The hexagonal boron nitride particles increase the thermal conductivity of the composite material disclosed herein. The hexagonal boron nitride particles typically comprise platelet-shaped hexagonal boron nitride particles. Platelet-shaped hexagonal boron nitride particles may also be referred to as flake-shaped or scale-like hexagonal boron nitride particles. The hexagonal boron nitride particles may be present as non-agglomerated boron nitride particles or non-agglomerated platelets in the composite material. The hexagonal boron nitride particles may also comprise platelet-shaped hexagonal boron nitride particles which are agglomerated with one another to boron nitride agglomerates. Also mixtures of agglomerates and non-agglomerated primary particles may be used. The boron nitride agglomerates may be spherical, irregularly shaped or flake-shaped. The flake-shaped agglomerates may have an aspect ratio of from 1 to 20. Also mixtures of agglomerates with different shapes may be used.

The mean aspect ratio of the platelet-shaped hexagonal boron nitride particles typically is at least 5. The aspect ratio is the ratio of the diameter to the thickness of the platelet-shaped hexagonal boron nitride particles. As used herein, the platelet-shaped hexagonal boron nitride particles are also referred to as boron nitride platelets. The aspect ratio of the boron nitride platelets may be at least 10, or at least 15, or at least 20. The mean aspect ratio of the boron nitride platelets may also be up to 40, or up to 100. The mean aspect ratio of the boron nitride platelets may be from 7 to 20, or from 20 to 40, or from 7 to 40, or from 10 to 40, or from 50 to 100. Typically, the mean aspect ratio of the boron nitride platelets is at most 500. The mean aspect ratio can be measured by scanning electron microscopy (SEM), by determining the aspect ratio of 20 particles, and calculating the mean value of the 20 individual values determined for the aspect ratio. The aspect ratio of an individual boron nitride platelet is determined by measuring the diameter and the thickness of the boron nitride platelet and calculating the ratio of the diameter to the thickness. Required magnification of the SEM images used to measure diameter and thickness of boron nitride platelets depends on the size of the platelets. Magnification should be at least 1000x, preferably at least 2000x. Where appropriate, i.e. for smaller platelets with a mean particle size (d₅₀) of 5 to 10 µm, a magnification of 5000x should be used.

In some embodiments, all hexagonal boron nitride particles are platelet-shaped. In some embodiments, all hexagonal boron nitride particles are non-agglomerated.

The mean particle size (d₅₀) of the hexagonal boron nitride particles may be from 0.5 to 500 µm. In some embodiments, the mean particle size (d₅₀) of the hexagonal boron nitride particles may be at most 250 µm, at most 150 µm or at most 100 µm. The mean particle size (d₅₀) of the boron nitride platelets may be from 0.5 to 100 µm. Preferably, the mean particle size (d₅₀) of the boron nitride platelets is at least 2 µm, more preferably at least 5 µm. The mean particle size (d₅₀) of the hexagonal boron nitride particles, of the boron nitride platelets and of the boron nitride agglomerates can be measured by laser diffraction.

The composite material may comprise from 10 to 40 percent by weight of hexagonal boron nitride particles, based on the total weight of the composite material. In some embodiments, the composite material comprises from 15 to 35 percent by volume of hexagonal boron nitride particles, based on the total weight of the composite material.

The through-plane thermal conductivity of the composite material may be at least 0.3 W/m*K. The through-plane thermal conductivity is measured when the composite material is compressed. For measuring the through-plane thermal conductivity, the composite material is compressed by at least 40% in direction of compression. The through-plane thermal conductivity is measured on a film sample of the composite material. The film sample has a thickness of 1 - 2 mm.

The composite material may also comprise further thermally conductive particles other than hexagonal boron nitride particles, for example aluminum oxide or aluminum nitride particles.

The composite material may further comprise fillers for improvement of the mechanical properties, such as glass fibers or carbon fibers.

Further disclosed herein is also a shaped article comprising the composite material as disclosed herein.

The shaped article may be a film. The shaped article may also be a strip, i.e. a part which is cut out or punched out from a film.

The film has a thickness and a width and a length. The thickness of the film typically is smaller than the width of the film. Typically, the film is compressible by at least 10% in direction of compression, i.e. by at least 10% of its thickness. This means that the film is compressible to a compressed thickness which is at most 90% of the thickness of the film in the uncompressed state. In other words, "compressible by 10% of its thickness" means "compressible by 10% of its thickness before compression". If the film is compressed by 10% of its thickness, this results in a thickness of the film after compression of 90% (= 100% - 10%) of its original thickness, i.e. of its thickness before compression.

The film may also be compressible by more than 10% of its thickness. For example, the film may be compressible by at least 30% or by at least 40%, or by at least 50%, or by at least 60%, or by at least 70% of its thickness. Typically, the film is compressible by at most 80% of its thickness. The density of the compressed film may be only slightly below the theoretical density of the composite material, which means that the porosity of the compressed film can be very low and only a small amount of pores of below 10% may remain.

The load which needs to be applied in order to compress the film by at least 10% of its thickness typically is at most 5 MPa, i.e. the film is compressible by at least 10% of its thickness with a load of at most 5 MPa. Also lower loads may be used. For example, a load of at most 2 MPa, or of at most 1 MPa, or of at most 0.5 MPa may be used.

The film may have a width of from 2 - 3 cm. The width of the film may also be smaller than 2 cm. The width of the film may also be larger than 3 cm. For example, the width of the film may be up to 30 cm, up to 40 cm or up to 50 cm. The thickness of the film may be from 0.1 to 10 mm. Typically, the thickness of the film is from 1 to 5 mm. The length of the film is not specifically limited and may have a length of several meters or even several kilometers. Typically, the film is wound onto a roll during its production. Strips having a length of 1 cm to 1 m, for example, may be cut out of the film.

The composite material as disclosed herein can be produced by a process comprising
providing hexagonal boron nitride particles and polytetrafluoroethylene,
mixing the hexagonal boron nitride particles and polytetrafluoroethylene, thereby obtaining a powder mixture,
extruding the powder mixture into an extruded strand,
shaping the extruded strand into a shaped article, wherein the shaped article has a length, and
stretching the shaped article to a length of at least 200% of its unstretched length, thereby obtaining a shaped article of the composite material.

The film as disclosed herein can be produced by a process comprising
providing hexagonal boron nitride particles and polytetrafluoroethylene,
mixing the hexagonal boron nitride particles and polytetrafluoroethylene, thereby obtaining a powder mixture,
extruding the powder mixture into an extruded strand,
shaping the extruded strand into a film, and
stretching the film to a length of at least 200% of its unstretched length.

For producing the composite material and the film as disclosed herein, hexagonal boron nitride particles and polytetrafluoroethylene as described above may be used.

The hexagonal boron nitride particles used for producing the composite material and the film as disclosed herein may have a specific surface area (BET) of at most 20 m²/g, preferably at most 10 m²/g. In some embodiments, the specific surface area of the hexagonal boron nitride particles is at most 5 m²/g. Typically, the specific surface area of the hexagonal boron nitride particles is at least 1 m²/g.

The hexagonal boron nitride particles and the polytetrafluoroethylene may be mixed using conventional mixing aggregates such as intensive mixers or ploughshare mixers.

Preferably, the mixing of the hexagonal boron nitride particles and polytetrafluoroethylene is done by wet mixing and subsequent drying.

When working with fine powder PTFE and dry mixing the PTFE with hexagonal boron nitride particles, it is difficult to add 30% by weight or more of boron nitride. This is due to the reduced ability of the PTFE particles to have particle to particle interactions before extrusion, i.e. in the ripened state, and the boron nitride particles just cover the larger powder particles of the fine powder PTFE. This causes the preform of the extruded strand to be fragile and fall apart when boron nitride loading is at or above 30% by weight.

For wet mixing of polytetrafluoroethylene and hexagonal boron nitride particles, a dispersion of PTFE is used. Hexagonal boron nitride particles are added to the dispersion of PTFE and are mixed in a stirred vessel. The wet mixture of polytetrafluoroethylene and hexagonal boron nitride particles is then dried. Drying may be carried out at a temperature of from 100 to 250 °C for 1 to 24 hours. By wet mixing, well mixed particles are obtained that can then be extruded into an extruded strand.

The powder mixture may also comprise further thermally conductive particles other than hexagonal boron nitride particles, for example aluminum oxide or aluminum nitride particles. The powder mixture may further comprise fillers for improvement of the mechanical properties, such as glass fibers or carbon fibers.

The obtained powder mixture is extruded into an extruded strand. Extruding is carried out as a paste extruding process. For extruding, processing aids such as lubricants may be added to the powder mixture.

The extruded strand typically has a round cross-sectional area having a diameter of from 1 to 40 mm, preferably from 6 to 20 mm. The extruded strand may also have a rectangular cross-sectional area or other forms of cross-sectional areas. The length of the extruded strand is not specifically limited; for example, the length of the extruded strand may up to 2 m, or more.

After the extrusion step, the extruded strand is shaped into a shaped article, for example a film. Shaping may be performed by calendaring. Calendaring may be performed at room temperature (23 °C).

The thickness of the film may be from 0.1 to 10 mm. The aspect ratio of the film, i.e. the ratio of the width to the thickness of the film, is larger than 1, and may be at least 10 or at least 40. The aspect ratio of the film may also be up to 100.

As a next step, the shaped article or film is stretched to a length of at least 200% of its unstretched length. The shaped article or film may also be stretched to a length of more than 200% of its unstretched length, it may be stretched to a length of up to 800% of its unstretched length. Stretching is performed at a temperature below the melting point of PTFE. Stretching may be performed at room temperature (23 °C) or at higher temperatures up to 250°C.

The shaped article or film as disclosed herein may be metallized or surface-treated. Suitable surface treatments are plasma treatments and etching processes, for example with sodium naphthalene.

The composite material, the shaped article and the film as disclosed herein may be used for heat dissipation in heat generating systems such as lithium ion batteries, fuel cells, electrolyzers, inverters, power electronics or electrochemical devices.

### Examples

### Example 1 (EX1)

Polytetrafluoroethylene dispersion in water with 21.3% solids, with a mean primary particle size d₅₀ of 200 nm of the PTFE particles and an extrusion pressure of 40 MPa of the dried PTFE powder, was mixed with hexagonal boron nitride particles (Cooling Filler Agglomerates CFA 150, available from 3M Technical Ceramics, Zweigniederlassung der 3M Deutschland GmbH, Kempten, Germany). Cooling Filler Agglomerates CFA 150 are irregularly shaped boron nitride agglomerates having a mean particle size d₅₀ of 90 µm (Mastersizer 2000, dry measurement). The mixing was performed in the following manner: In 360 g of de-ionized water, 20 drops (0.8 g) of a surfactant (Silwet L-77, available from Momentive Performance Materials Inc., Waterford, USA) were added in a 600 milliliter beaker. Then 40 g of CFA 150 were added slowly and stirred at a low level. In a 2 liter beaker, 748 g of the PTFE dispersion described above (with 21.3% solids) was first diluted with 52 g de-ionized water and then the boron nitride/water mixture was added fast to the diluted PTFE dispersion. Subsequently, 12 g of 10% HCI solution were added and the stirring speed was increased. The addition of 12 g of 10% HCI was repeated a second time. The obtained suspension coagulated quickly and the water phase was clear. The entire solid phase was collected by decanting the clear water phase and subsequently dried at 190°C for 5 hours. Thereby, a powder mixture of polytetrafluoroethylene and hexagonal boron nitride particles was obtained.

The dried powder mixture was homogenized and imbibed with Shellsol T lubricant and allowed to ripen for 12 hours and extruded at an extrusion ratio of 16 to an extruded strand having a round cross-sectional area with a diameter of 6 mm. The extrusion ratio is defined as the starting cross-sectional area before extrusion divided by the cross-sectional area of the extruded strand. The extruded strand was then calendered into a flat film with a thickness of 1.2 mm. As used herein, the film may also be referred to as "ribbon". The ribbon had a width of 20 mm. The ribbon was dried at 220 °C for 10 hours. Then the ribbon was stretched to a length of 400% of its unstretched length at a rate of 6000 mm/min and a temperature of 225 °C. The stretched ribbon was measured for its thermal conductivity. While measuring thermal conductivity, the ribbon was compressed and thermal conductivity was continuously measured while pressure was increased. Pressure was increased until no more compression was possible. Samples with dimensions 1 cm x 1 cm x 1.2 mm were used for thermal conductivity measurements.

For measuring thermal conductivity, the transient plane heat source (hot disc) method is used and carried out with the Hot Disk TPS 2500S (Hot Disk AB, Gothenburg, Sweden) according to ISO 22007-2:2015. Measurements are taken at 23 °C. Thermal conductivity (TC) is determined using a Kapton sensor of 0.9 mm radius (Type C102003).

After the calendering process and before stretching, the ribbon had a density of 1.55 g/cm³. The density was measured geometrically and with a Mettler balance.

After stretching, the ribbon had a density of 0.6 g/cm³. The density was measured geometrically and with a Mettler balance. The measured density corresponds to a porosity of 73%, since the density of a PTFE/BN composite, without any porosity, is 2.2 g/cm³.

The composition is shown in Table 1, and Table 2 shows the test results and the ability of the ribbon to be compressed.

### Examples 2 to 4 (EX2 to EX4)

Example 1 was repeated, with the exception that the composition of the powder mixture was different (see Table 1). In Examples 2 and 4, Cooling Filler Flakes CFF 500-3 are used, available from 3M Technical Ceramics, Zweigniederlassung der 3M Deutschland GmbH, Kempten, Germany. Cooling Filler Flakes CFF 500-3 are flake-shaped boron nitride agglomerates having platelet-shaped primary particles of boron nitride with a mean particle size d₅₀ of 3 µm and a maximum particle size of the agglomerates of 500 µm. For Example 3, the boron nitride agglomerates CFA 150 of Example 1 are used.

For Examples 2 to 4, the polytetrafluoroethylene dispersion in water with 21.3% solids of Example 1 was used and mixed with the boron nitride particles as described for Example 1 and in an amount as shown in Table 1.

After the calendering process and before stretching, the ribbon had a density of 1.55 g/cm³. The density was measured geometrically and with a Mettler balance.

After stretching, the ribbon had a density of 0.6 g/cm³. The density was measured geometrically and with a Mettler balance. The measured density corresponds to a porosity of 73%, since the density of a PTFE/BN composite, without any porosity, is 2.2 g/cm³.

The composition is shown in Table 1, and Table 2 shows the test results and the ability of the ribbon to be compressed.

### Example 5 (EX5)

In Example 5, platelet-shaped boron nitride particles CFP 012 were used, available from 3M Technical Ceramics, Zweigniederlassung der 3M Deutschland GmbH, Kempten, Germany. The mean particle size (d₅₀) of the boron nitride platelets is 12 µm (Mastersizer 2000, wet measurement). For the powder mixture of Example 5, in a first step the CFP 012 platelets were wet mixed with a PTFE dispersion in water with 25% solids content, with a mean primary particle size d₅₀ of 200 nm of the PTFE particles and an MFI of 6 of the PTFE particles, in the following manner: 100 g of the PTFE dispersion with 25% solids content was diluted with 800 g de-ionized water in a 2 liter beaker. 100 g CFP 012 were added to the mixture at low mixing speeds. Afterwards 12 g of 10% HCI solution was added and after 15 minutes of mixing and then allowing the mixture to sit, the material coagulated. The obtained material was dried at 190°C for 5 hours. After drying, the obtained material was pressed into a block at room temperature at 80 MPa of pressure. The block was broken down, thereby obtaining agglomerates of boron nitride particles with PTFE in the interstitial space. The boron nitride/PTFE agglomerates comprise 80% by weight of CFP 012 and 20% by weight of PTFE. In a second step for producing the powder mixture of Example 5, 1.4 g (35 drops) of Silwet L-77 were added to 675 g of de-ionized water. 94 g of the boron nitride/PTFE agglomerates produced in the first step as described above were added to the water to obtain an aqueous boron nitride/PTFE suspension. In a 2 liter beaker, 720.2 g of a polytetrafluoroethylene dispersion in water with 21.7% solids, with a mean particle size d₅₀ of 200 nm of the PTFE particles and an extrusion pressure of 40 MPa of the dried PTFE powder, were poured, then the aqueous boron nitride/PTFE suspension was quickly added. After a short stirring time of 5 minutes, 13 g of a 10% HCI solution were added to the mixture and then a coagulate formed after 1 minute. The coagulate is dried at 190°C for 5 hours. Thereby, a powder mixture of polytetrafluoroethylene and hexagonal boron nitride particles was obtained.

The further steps were the same as in Example 1.

After the calendering process and before stretching, the ribbon had a density of 1.55 g/cm³. The density was measured geometrically and with a Mettler balance.

After stretching, the ribbon had a density of 0.6 g/cm³. The density was measured geometrically and with a Mettler balance. The measured density corresponds to a porosity of 73%, since the density of a PTFE/BN composite, without any porosity, is 2.2 g/cm³.

The composition is shown in Table 1, and Table 2 shows the test results and the ability of the ribbon to be compressed.

### Comparative Example 1 (CEX1)

As in Example 1, a stretched ribbon of PTFE has been produced, but without adding hexagonal boron nitride platelets or any other thermally conductive filler. The stretched ribbon of PTFE was made using the commercially available product TF 2025 Z (fine powder PTFE, available from Dyneon GmbH, Burgkirchen, Germany). As in Example 1, thermal conductivity of the ribbon was measured with increasing pressure.

After the calendering process and before stretching, the ribbon had a density of 1.55 g/cm³. The density was measured geometrically and with a Mettler balance.

After stretching, the ribbon had a density of 0.6 g/cm³. The density was measured geometrically and with a Mettler balance. The measured density corresponds to a porosity of 73%, since the density of PTFE, without any porosity, is 2.2 g/cm³.

Table 2 shows the test results and the ability of the ribbon to be compressed.

### Comparative Examples 2 to 6 (CEX2 to CEX6)

Examples 1 to 5 were repeated, with the exception that the ribbon was not stretched. After a low compression of the ribbons, the pressure level in the equipment to measure the thermal conductivity could not be raised, because the unstretched ribbons of these Comparative Examples are stiff and non-compressible, and the maximal pressure of the equipment to measure the thermal conductivity was reached.

The ribbons of Comparative Examples 2 to 6 had a density of 1.55 g/cm³. The density was measured geometrically and with a Mettler balance.

The composition is shown in Table 1, and Table 2 shows the test results and the ability of the ribbon to be compressed.

**Table 1:**

| | Grade of hexagonal boron nitride particles | Content of hexagonal boron nitride particles [wt.-%] | Ribbon stretched/ unstretched |
|---|---|---|---|
| EX1 | CFA 150 | 20 | stretched |
| EX2 | CFF 500-3 | 20 | stretched |
| EX3 | CFA 150 | 30 | stretched |
| EX4 | CFF 500-3 | 30 | stretched |
| EX5 | CFP 012 | 30 | stretched |
| CEX1 | none | 0 | stretched |
| CEX2 | CFA 150 | 20 | unstretched |
| CEX3 | CFF 500-3 | 20 | unstretched |
| CEX4 | CFA 150 | 30 | unstretched |
| CEX5 | CFF 500-3 | 30 | unstretched |
| CEX6 | CFP 012 | 30 | unstretched |

**Table 2:**

| | Thermal conductivity at maximal compression [W/m*K] | Maximal compression [MPa] | Comments about compressibility |
|---|---|---|---|
| EX1 | 0.40 | 0.4 ^{a)} | Very good compressibility, soft ribbon |
| EX2 | 0.42 | 0.4 ^{a)} | Very good compressibility, soft ribbon |
| EX3 | 0.65 | 0.4 ^{a)} | Very good compressibility, soft ribbon |
| EX4 | 0.51 | 0.4 ^{a)} | Very good compressibility, soft ribbon |
| EX5 | 0.65 | 1.0 ^{b)} | Excellent compressibility, soft ribbon |
| CEX1 | 0.19 | | |
| CEX2 | 0.45 | - | Almost no compressibility, hard ribbon |
| CEX3 | 0.46 | - | Almost no compressibility, hard ribbon |
| CEX4 | 0.65 | - | Almost no compressibility, hard ribbon |
| CEX5 | 0.59 | - | Almost no compressibility, hard ribbon |
| CEX6 | 0.64 | - | Almost no compressibility, hard ribbon |

| | | | |
|---|---|---|---|
| ^{a)} At a compression of 0.4 MPa, the thickness was reduced from 1.2 mm down to 0.6 mm. ^{b)} At a compression of 1 MPa, the thickness value could be reduced even further to 0.4 mm. In this manner a compressibility of about 67% could be achieved, which corresponds closely to the porosity of 73%. | | | |

The unstretched ribbons of Comparative Examples 2 to 6 are hard and not suitable to fill in gaps, when compressed. The stretched ribbons of Examples 1 to 5 are very compressible and furthermore demonstrate good thermal conductivity under compression. Since they are quite compressible, they can fill small gaps and can compensate height differences between individual cells of lithium ion batteries and fuel cells, and result in a very thin thermal bridge. Since they are based on boron nitride/PTFE combinations, the electrical insulating properties are excellent. These ribbons can be easily removed in case repairs on the battery or fuel cell modules are necessary. Due to the chemical resistance of PTFE, the composite material and the ribbons have a good corrosion resistance.

## Claims

1. A composite material comprising polytetrafluoroethylene and hexagonal boron nitride particles, wherein the composite material is porous, and wherein the composite material is compressible.

2. The composite material of claim 1, wherein the composite material has a porosity of at least 10%.

3. The composite material of claim 1 or 2, wherein the composite material comprises a plurality of nodes which are interconnected by a plurality of fibrils.

4. The composite material of any of claims 1 to 3, wherein the composite material is compressible by at least 10% in direction of compression.

5. The composite material of any of claims 1 to 4, wherein the hexagonal boron nitride particles comprise platelet-shaped hexagonal boron nitride particles.

6. The composite material of any of claims 1 to 5, wherein the hexagonal boron nitride particles comprise platelet-shaped hexagonal boron nitride particles which are agglomerated with one another to boron nitride agglomerates.

7. The composite material according to any one of claims 1 to 6, wherein the composite material comprises from 10 to 40 percent by weight of hexagonal boron nitride particles, based on the total weight of the composite material.

8. The composite material of any of claims 1 to 7, wherein the through-plane thermal conductivity of the composite material is at least 0.3 W/m*K, and wherein the through-plane thermal conductivity is measured when the composite material is compressed.

9. A shaped article comprising the composite material of any of claims 1 to 8.

10. The shaped article of claim 9, wherein the shaped article is a film.

11. The film of claim 10, wherein the film has a thickness and a width, and wherein the thickness of the film is smaller than the width of the film, and wherein the film is compressible by at least 10% of its thickness.

12. The film of claim 10 or 11, wherein the film is compressible by at least 10% of its thickness with a load of at most 5 MPa.

13. A process for producing a composite material according to claim 10, the process comprising
providing hexagonal boron nitride particles and polytetrafluoroethylene,
mixing the hexagonal boron nitride particles and polytetrafluoroethylene, thereby obtaining a powder mixture,
extruding the powder mixture into an extruded strand,
shaping the extruded strand into a shaped article, wherein the shaped article has a length, and
stretching the shaped article to a length of at least 200% of its unstretched length, thereby obtaining a shaped article of the composite material.

14. The process according to claim 13, wherein the mixing of the hexagonal boron nitride particles and polytetrafluoroethylene is done by wet mixing and subsequent drying.

15. Use of the composite material according to any of claims 1 to 8, of the shaped article according to claims 9 and 10 and of the film according to claims 11 and 12 for heat dissipation in heat generating systems such as lithium ion batteries, fuel cells, electrolyzers, inverters, power electronics or electrochemical devices.
